# EUROPEAN PATENT SPECIFICATION

(11) **EP 1 141 731 B1**
(45) Date of publication and mention of the grant of the patent: **07.05.2003**
(21) Application number: 99967766.9
(22) Date of filing: 30.12.1999
(51) Int. Cl.: G01R 1/073

(54) **DUAL-PIN PROBE FOR TESTING CIRCUIT BOARDS**
DOPPELSPITZEN-PRÜFTSTIFT ZUM PRÜFEN VON LEITERPLATTEN
SONDE A DOUBLE BROCHE POUR CONTROLE DE CARTE DE CIRCUIT IMPRIME

(30) Priority: 30.12.1998 US 114392 P
(43) Date of publication of application: 10.10.2001
(73) Proprietor: Proteus Corporation, Englewood, CO 80150 (US)
(72) Inventor: LUCAS, Brian K., Cheddar Somerset BS27 3AN (GB); STOCKFORD, Brian, Bishopston, Bristol BS7 8LX (GB)
(74) Representative: Goodanew, Martin Eric
(86) International application number: US9931236
(87) International publication number: WO00039595

(56) References cited:
- EP-A- 0 290 182
- EP-A- 0 468 153
- EP-A- 0 496 984
- WO-A-99/10749
- FR-A- 2 605 414
- US-A- 5 006 793
- US-A- 5 264 788
- "PROBE COLLISION AVOIDANCE PROCEDURE FOR PARAMETRIC TESTERS" IBM TECHNICAL DISCLOSURE BULLETIN, vol. 32, no. 8B, 1 January 1990 (1990-01-01), pages 438-442, XP000082148

## Description

### Field of the Invention

The invention relates to the field of testing devices, and in particular, to a dual-pin probe for circuit board testing.

### Problem

Manufacturers of circuit boards generally test the circuit boards coming off of an assembly line to ensure proper performance and quality. Consequently, the time and cost of manufacturing the circuit boards include the time and cost of testing the circuit boards. Manufacturers try to lower the time and cost of testing without degrading the quality of the circuit boards.

A presently used testing method involves manually testing signals at various nodes on the circuit boards. The test equipment used is generally a conventional oscilloscope or a test probe. The conventional test probe has a signal lead and a ground lead. For manual circuit board testing, a tester touches the ground lead to a ground node on the circuit board. The tester touches the signal lead to a signal node that carries the signal to be tested. The tester records and verifies data read from the test probe.

One problem with the present testing method is speed. As the circuit boards become more densely populated with components, the number of nodes to be tested increases. The manual testing is slow, and testing many nodes manually increases the testing time and manufacturing costs of the circuit board. Another problem with the present testing method is precision. Manual testing brings in the possibility of human error. As the components on the circuit board move closer together, the chance of manual testing errors increases. Test errors could occur by probing the wrong node, or probing two nodes at the same time by mistake. Test errors could also occur by simply mis-recording the test data.

An automated printed circuit board testing apparatus is disclosed in published PCT Application WO 99/10749 where the automated probe is equipped with a probe head having two probe leads for connecting to two conductors on the printed circuit board. One of the probe leads is mounted on the probe head coaxially with the probe shaft that connects the probe head to a rotational motor that serves to rotate the entire probe head. A second probe lead is connected to a carriage that is connected to the probe head via a radial motor to thereby enable the second probe lead to move in a radial direction with respect to the first probe lead. Thus, the second probe lead moves in a polar coordinate set of axes with respect to the first probe lead, with the probe motor controlling the radial movement and the probe shaft controlling the angular displacement. However, the use of the radial motor located at the end of the probe shaft occupies a significant amount of space and is limited in its application to circuit testing in confined spaces.

U.S. Patent No. 5,006,793 discloses a high-frequency active probe that uses a semi-rigid coaxial cable line as the probe conductor. The ground contact needle is connected to a wiper that interconnects the ground contact needle with the coaxial line outer conductor. The inner conductor of the coaxial line is connected to a signal contact needle which is moved via an X-Y-Z positioner mechanism that moves over the surface of the printed circuit board to contact selected signal points. However, the use of the X-Y-Z positioner mechanism requires the use of a significant amount of space and is not applicable to applications where the contacts to be tested are located in a confined space.

### Solution

The above described problems are solved by the present dual pin probe for testing printed circuit boards, which uses a compact dual pin test probe head. The dual-pin probe has a probe head that is coupled to a robotic system which functions to position the dual-pin probe relative to a circuit board under test. The probe head is equipped with a signal pin and a ground pin that both extend from a face of the probe head and are substantially parallel to one another. The signal pin is fixedly mounted on the probe head while the ground pin is mounted on an end of a pivot arm so that the distance between the ground pin and the signal pin can be varied by rotating the pivot arm on which the ground pin is mounted. Thus, the position of the ground pin with respect to the signal pin can be controlled without the need for complex mechanical apparatus, since only a single rotation motor is used to operate the pivot arm to adjust the spacing between the ground pin and the signal pin to thereby precisely contact nodes on the circuit board, even in confined spaces.

### Brief Description of the Drawings

Figure 1 shows a first embodiment of a dual-pin probe constructed according to the invention;
Figure 2 illustrates the dual-pin probe of Figure 1 coupled to a robot interface;
Figure 3 shows another embodiment of a dual-pin probe according to the invention;
Figure 4 shows the dual-pin probe of Figure 3 coupled to a robot interface.

### Detailed Description of the Invention

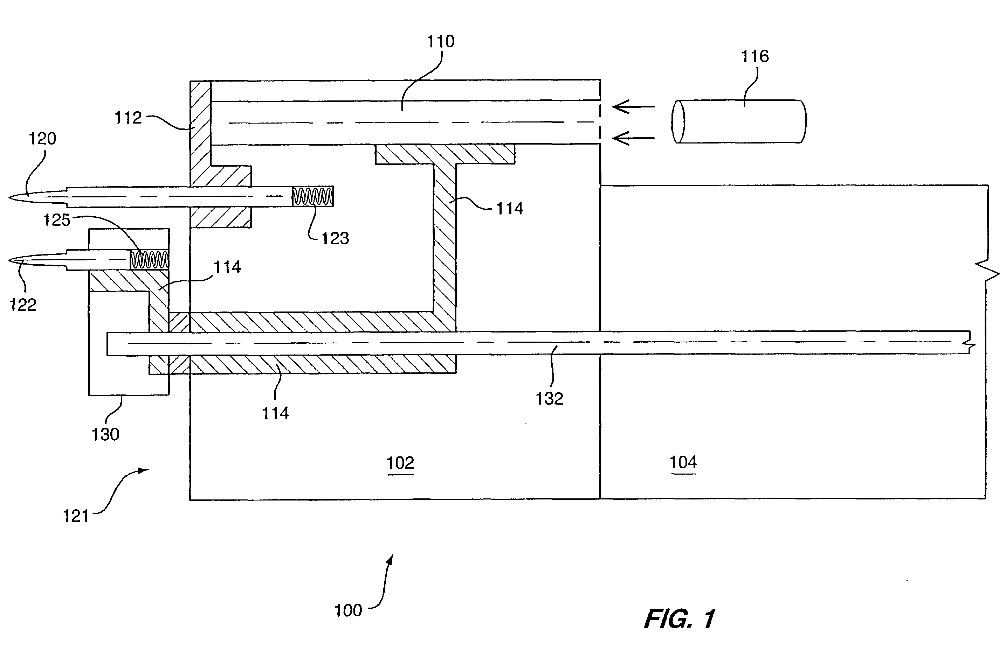

### Dual-pin probe - Figures 1-2

Figures 1-2 depict a first embodiment of a dual-pin probe 100 in accord with the present invention. The dual-pin probe 100 has a probe body 104, a probe head 102, a signal pin 120, a ground pin 122, a pivot arm 130, and a pivot 132. The probe body 104 connects to a robot interface (not shown) of a robotic system (not shown), the robotic system configured to manipulate the dual-pin probe 100. The probe head 102 connects to the probe body 104, and includes a contact tube 110, a signal connection 112, and a ground connection 114. The probe head 102 is insulated to prevent short circuits. The contact tube 110 is configured to hold an electronics test probe, such as an active, passive, or logic probe. The contact tube 110 size is preferably flexible to accommodate different size test probes. Inside the contact tube 110, the signal connection 112 connects with a signal lead of the test probe. The signal connection 112 is for example a gold plated connection. The ground connection 114 connects with a ground lead of the test probe. The ground connection 114 is for example a gold plated connection.

The signal pin 120 mounts onto the probe head 102 and protrudes perpendicularly from a face 121 of the probe head 102. The signal pin 120 is for example made from a gold plated material. The signal pin 120 is preferably mounted on a spring 123 with a retraction of about 0.4 cm (0.157 inches) at a maximum. The signal pin 120 connects to the signal connection 112, creating a direct connection from the signal pin 120 to the signal lead of the test probe.

The pivot 132 extends from the probe body 104 through the probe head 102 to protrude perpendicularly to the face 121 of the probe head 102. The pivot arm 130 mounts on the pivot 132 and is substantially parallel to the face 121 of the probe head 102. The pivot 132 is configured to rotate clockwise or counter-clockwise which in turn rotates the pivot arm 130 in a 360 degree angle. The ground pin 122 mounts onto the pivot arm 130 and protrudes perpendicularly from the pivot arm 130 so that the ground pin 122 and the signal pin 12C are aligned substantially parallel to each other. The ground pin 122 is for example made from a gold plated material. The ground pin 122 is preferably mounted on a spring 125 with a retraction of about 0.4 cm (0.157 inches) at a maximum. The ground pin 122 connects to the ground connection 114 creating a direct connection from the ground pin 122 to the ground lead of the test probe. The signal pin 120 and the ground pin 122 are preferably fixed in length to ensure that minimal inductance is introduced into measured signals.

In operation, a test probe mounts inside an insulated connector 116. The insulated connector 116 and the test probe are inserted into the contact tube 110. The insulated connector 116 holds the test probe inside of the contact tube 110. The robotic system positions the dual-pin probe 100 over a circuit board so that the face 121 of the probe head 102 is substantially parallel to the circuit board. The robotic system adjusts the linear distance between the signal pin 120 and the ground pin 122 by rotating the pivot arm 130. The robotic system increases the distance between the signal pin 120 and the ground pin 122 by rotating the pivot arm 130 away from the signal pin 120. The robotic system decreases the distance between the signal pin 120 and the ground pin 122 by rotating the pivot arm 130 toward the signal pin 120. The range of distance between the signal pin 120 and the ground pin 122 can be for example 0.127 cm to 1.27 cm (0.050 inches to 0.500 inches) with a resolution of 0.00254 cm (0.001 inches).

When the distance between the signal pin 120 and the ground pin 122 is adjusted, the robotic system rotates the dual-pin probe 100 to respectively position the signal pin 120 and the ground pin 122 directly adjacent to a signal node and a ground node on the circuit board. With the signal pin 120 and the ground pin 122 properly positioned, the robotic system moves the dual-pin probe 100 so that the signal pin 120 comes into contact with the signal node and the ground pin 122 comes into contact with the ground node. As stated above, the signal pin 120 and the ground pin 122 are preferably spring-loaded to account for mis-alignment of the dual-pin probe 100 or non-linearities on the circuit board. The test probe is activated within the contact tube 110 to measure a signal on the signal node. The robotic system then moves the dual-pin probe 100 to another position on the circuit board to measure another signal.

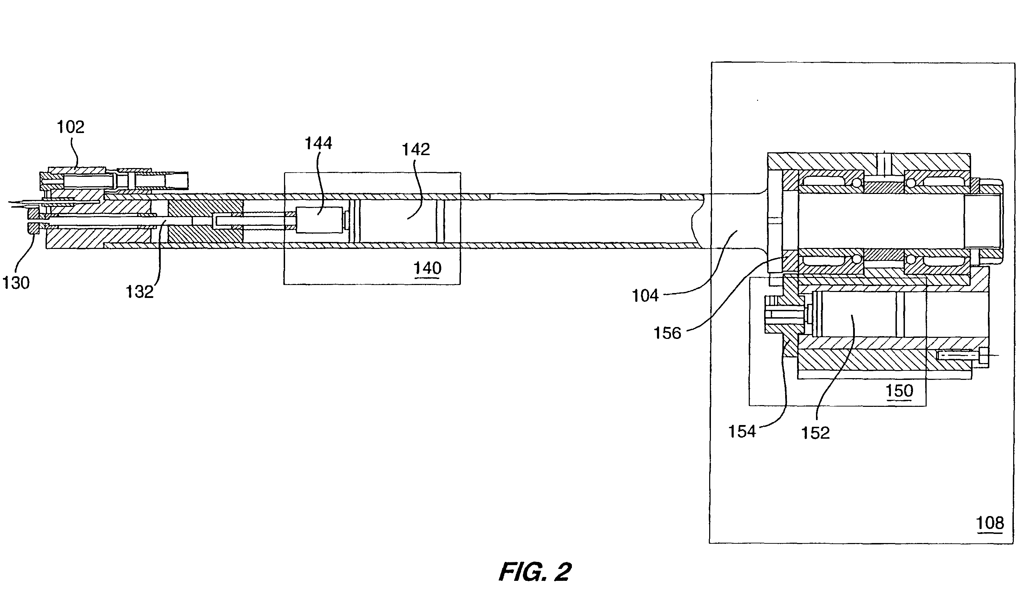

Figure 2 shows the dual-pin probe 100 connected to a robot interface 108. The probe body 104 mounts onto the robot interface 108. The robot interface 108 connects to a robotic system (not shown), wherein the robotic system is configured to manipulate the dual-pin probe 100 and the robot interface 108. The probe body 104 includes a pivot actuator 140. The pivot actuator 140 connects to the pivot 132. The pivot actuator 140 has a servomotor 142 and a spring-loaded zero backlash coupling 144. The servomotor 142 is for example a 24 VDC motor using a zero backlash gearhead. The servomotor 142 couples to the pivot 132 through the spring-loaded zero backlash coupling 144. The robot interface 108 includes a probe actuator 150. The probe actuator 150 preferably has a servomotor 152 coupled to an anti-backlash reduction gear 154. The servomotor 152 is for example a 24 VDC motor using a zero backlash gearhead. The reduction gear 154 couples to a gear ring 156, such that the gear ring 156 is keyed onto the probe body 104.

In operation, the robotic system rotates the pivot 132 by activating the servomotor 142 in the pivot actuator 140. The pivot 132 rotates the pivot arm 130 and adjusts the distance between the signal pin 120 and the ground pin 122. The robotic system rotates the pivot 132 until the ground pin 122 is the desired distance from the signal pin 120. A high-resolution rotary encoder (not shown) coupled to the servomotor 142 and an optical marker pulse preferably provide the robotic system with information on the position of the pivot 132 and/or pivot arm 130. The robotic system then rotates the entire dual-pin probe 100 by activating the servomotor 152 in the probe actuator 150. The servomotor 152 rotates the reduction gear 154. If desired, the reduction gear 154 increases the amount of torque generated by the servomotor 152. The reduction gear 154 turns the gear ring 156 coupled to the probe body 104. The gear ring 156 turns the entire dual-pin probe 100. The probe actuator 150 rotates the dual-pin probe 100 until the signal pin 120 and the ground pin 122 are properly orientated adjacent to a circuit board. A high-resolution rotary encoder (not shown) and an optical marker pulse preferably provide the robotic system with information on the position of the dual-pin probe 100.

The dual-pin probe 100 in Figures 1-2 is a significant advance over the prior art. The dual-pin probe 100 automates the testing of circuit boards. Automated testing with the dual-pin probe 100 is fast and accurate, which is an advantage on highly populated boards. The dual-pin probe 100 reduces testing errors and lowers manufacturing costs of circuit boards.

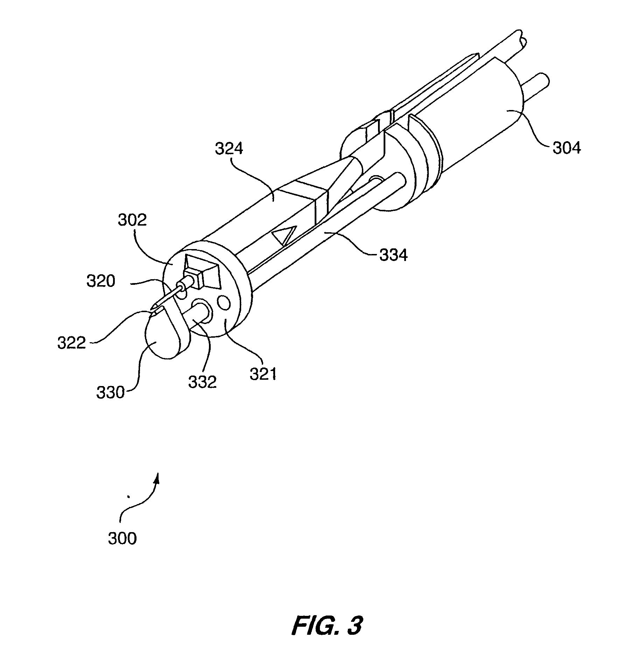

### Dual-Pin Probe - Figures 3-4

Figures 3-4 depict another embodiment of a dual-pin probe 300 in accord with the present invention. Figure 3 shows the dual-pin probe 300 with a probe body 304, a probe head 302, a signal pin 320, a ground pin 322, support shafts 334, a pivot arm 330, a pivot 332, and a FET probe 324. The probe body 304 connects to a robot interface (not shown) of a robotic system (not shown), the robotic system configured to manipulate the dual-pin probe 300. The probe head 302 connects to the probe body 304 through the support shafts 334. The signal pin 320 mounts onto a face 321 of the probe head 302 in a fixed position extending substantially perpendicular to the face 321. The signal pin 320 is for example made from a gold plated material. The FET probe 324 connects to the probe head 302, with a signal lead of the FET probe 324 connecting to the signal pin 320. The FET probe 324 is fastened to the probe head 302 with fasteners such as set screws or clamps. The FET probe 324 can for example be a Tektronix P6245 FET probe.

The pivot 332 extends from the probe body 304 through the probe head 302 to protrude perpendicularly to the face 321 of the probe head 302. The pivot arm 330 mounts on the pivot 332 and is preferably parallel to the face 321 of the probe head 302. The pivot 332 is configured to rotate clockwise or counter-clockwise which in turn rotates the pivot arm 330 in a 360 degree angle. The ground pin 322 mounts onto the pivot arm 330 and protrudes perpendicularly from the pivot arm 330 so that the ground pin 322 and the signal pin 320 are aligned substantially parallel to each other. The ground pin 322 is for example made from a gold plated material. A flexible wire (not shown) connects the ground pin 322 to a ground lead of the FET probe 324. The signal pin 320 and the ground pin 322 are fixed in length to ensure that minimal inductance is introduced into measured signals.

The signal pin 320 and the ground pin 322 are independently retractable. The signal pin 320 is retractable because the support shafts 334 are mounted on precision bearings inside of the probe body 304 to allow for axial movement of the probe head 302. The probe head 302 could retract up to 0.4 cm (0.157 inches), for example. The ground pin 322 is retractable because the pivot 332 mounts on precision bearings inside of the probe body 304 and inside the probe head 302 to allow for axial movement of the pivot arm 330. In one example, the pivot arm 330 retracts up to 0.3 cm (0.118 inches).

In operation, the robotic system positions the dual-pin probe 300 over a circuit board so that the face 321 of the probe head 302 is substantially parallel to the circuit board. The robotic system adjusts the linear distance between the signal pin 320 and the ground pin 322 by rotating the pivot arm 330. The robotic system increases the distance between the signal pin 320 and the ground pin 322 by rotating the pivot arm 330 away from the signal pin 320. The robotic system decreases the distance between the signal pin 320 and the ground pin 322 by rotating the pivot arm 330 toward the signal pin 320. The range of distance between the signal pin 320 and the ground pin 322 is typically between about 0.127 cm and 1.9 cm (0.050 inches and 0.750 inches) with a resolution of 0.001 cm (0.0004 inches).

When the distance between the signal pin 320 and the ground pin 322 is adjusted, the robotic system rotates the dual-pin probe 300 to position the signal pin 320 and the ground pin 322 adjacent to a signal node and a ground node on the circuit board. With the signal pin 320 and the ground pin 322 properly positioned, the robotic system moves the dual-pin probe 300 so that the signal pin 320 comes into contact with the signal node and the ground pin 322 comes into contact with the ground node. As stated above, the signal pin 320 and the ground pin 322 are independently retractable to account for mis-alignment of the dual-pin probe 300 or non-linearities on the circuit board. The FET probe 324 is activated to measure a signal on the signal node. The robotic system then moves the dual-pin probe 300 to another position on the circuit board to measure another signal.

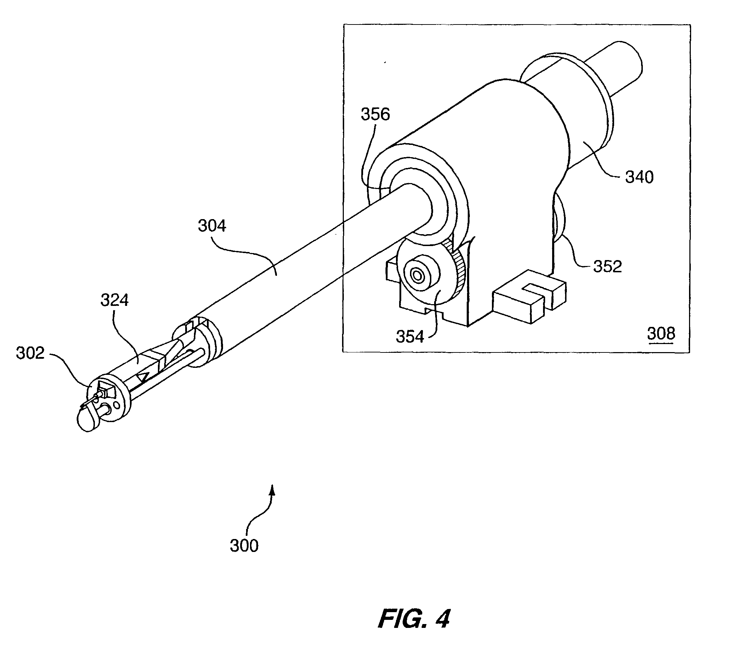

Figure 4 shows the dual-pin probe 300 connected to a robot interface 308. The probe body 304 mounts onto the robot interface 308. The robot interface 308 connects to a robotic system (not shown), wherein the robotic system is configured to manipulate the dual-pin probe 300 and the robot interface 308. The robot interface 308 includes a pivot actuator 340 and a probe actuator. The pivot actuator 340 connects to the pivot 332 in the dual-pin probe 300. The pivot actuator 340 preferably has a first servomotor and a high-precision bellows coupling. The first servomotor can for example be a 24 VDC motor using a zero backlash gearhead. The first servomotor couples to the pivot 332 through the high-precision bellows coupling. The probe actuator has a second servomotor 352 coupled to an anti-backlash reduction gear 354. The second servomotor 352 can for example be a 24 VDC motor using a zero backlash gearhead. The reduction gear 354 couples to a gear ring 356, such that the gear ring 356 is keyed onto the probe body 304.

In operation, the robotic system rotates the pivot 332 by activating the first servomotor in the pivot actuator 340. The pivot 332 rotates the pivot arm 330 and adjusts the distance between the signal pin 320 and the ground pin 322. The robotic system rotates the pivot 332 until the ground pin 322 is the desired distance from the signal pin 320. A high-resolution encoder (not shown) coupled to the first servomotor and optical switches (not shown) preferably provide the robotic system with information on the position of the pivot 332 and/or pivot arm 330. The robotic system then rotates the entire dual-pin probe 300 by activating the second servomotor 352 in the probe actuator. The second servomotor 352 rotates the reduction gear 354. If desired, the reduction gear 354 increases the amount of torque generated by the second servomotor 352. The reduction gear 354 turns the gear ring 356 coupled to the probe body 304. The gear ring 356 turns the entire dual-pin probe 300. The robotic system rotates the dual-pin probe 300 until the signal pin 320 and the ground pin 322 are properly orientated adjacent to a circuit board. A high-resolution encoder (not shown) and optical switches (not shown) preferably provide the robotic system with information on the position of the dual-pin probe 300.

### Summary

The dual-pin probe uses a signal pin that is fixedly mounted on the probe head while the ground pin is mounted on an end of a pivot arm so that the distance between the ground pin and the signal pin can be varied by rotating the pivot arm on which the ground pin is mounted. Thus, the position of the ground pin with respect to the signal pin can be controlled without the need for complex mechanical apparatus, since only a single rotation motor is used to operate the pivot arm to adjust the spacing between the ground pin and the signal pin to thereby precisely contact nodes on the circuit board, even in confined spaces.

## Claims

1. A dual-pin probe (100) configured for manipulation by a robot to facilitate testing of a circuit board, comprising:
a probe body (104) configured for connection to the robot;
a probe head (102) coupled to the probe body (104), with a distal end of the probe head (102) configured for positioning adjacent to the circuit board;
a first pin (120) extending from the distal end of the probe head (102) and located in a fixed position with respect to the probe head (102); wherein said dual-pin probe (100) is further **CHARACTERIZED BY**:
a second pin (122) connected to an end of a pivot arm (130) in a fixed location and extending from the distal end of the probe head (102), where the pivot arm (130) is rotatable to vary the distance between the first pin (120) and the second pin (122).

2. The dual-pin probe in claim 1 further comprising:
a pivot actuator (140), which is coupled to the pivot arm (130) by a pivot (132), for rotating the pivot arm (130).

3. The dual-pin probe in claim 1, wherein the pivot arm (130) is configured to rotate in a plane that is substantially parallel to the distal end of the probe head (102).

4. The dual-pin probe in claim 1, wherein the second pin (122) is retractably mounted onto the pivot arm (130).

5. The dual-pin probe in claim 1 further comprising:
a test probe (116) coupled to the probe head (102), wherein a first lead of the test probe (116) connects to the first pin (120) and a second lead on the test probe (116) connects to the second pin (122).

6. The dual-pin probe in claim 5 wherein the probe head (102) includes:
a contact tube (110) configured to house the test probe.

7. The dual-pin probe in claim 1, wherein the first pin (120) is retractably mounted onto the probe head (102).

8. The dual-pin probe in claim 1, wherein the first pin (120) is substantially parallel to the second pin (122).

9. An automated method of testing a circuit board, comprising the steps of:
identifying first and second test nodes on the circuit board;
determining a linear distance between and an orientation of the first and second test nodes;
varying a distance between a first (120) pin and a second pin (122) of a probe head (102);
positioning the probe head so that the first pin is adjacent to the first test node and the second pin is adjacent to the second test node;
contacting the first pin to the first node; and
contacting the second pin to the second node;
wherein said method is further **characterized in that** the step of varying is carried out by rotating a pivot arm (130) on which the second pin is fixedly mounted to match the linear distance.

10. The method in claim 9 further comprising the step of:
connecting a first lead of a test probe (116) to the first pin and a second lead of the test probe to the second pin.

## Patentansprüche

1. Doppelstift-Prüfspitze (100), die so ausgeführt ist, dass sie von einem Roboter betätigt werden kann, um das Prüfen einer Leiterplatte zu erleichtem, die umfasst:
einen Prüfspitzenkörper (104), der so ausgeführt ist, dass er mit dem Roboter verbunden wird;
einen Prüfspitzenkopf (102), der mit dem Prüfspitzenkörper (104) verbunden ist, wobei ein vorderes Ende des Prüfspitzenkopfes (102) so ausgeführt ist, dass es an die Leiterplatte angrenzend positioniert wird;
einen ersten Stift (120), der sich von dem vorderen Ende des Prüfspitzenkopfes (102) erstreckt und an einer unveränderlichen Position in Bezug auf den Prüfspitzenkopf (102) angeordnet ist, wobei die Doppelstift-Prüfspitze (100) des Weiteren **gekennzeichnet ist durch**:
einen zweiten Stift (122), der mit einem Ende eines Schwenkarms (130) an einer unveränderlichen Position verbunden ist und sich von dem vorderen Ende des Prüfspitzenkopfes (102) aus erstreckt, an dem der Schwenkarm (130) gedreht werden kann, um den Abstand zwischen dem ersten Stift (120) und dem zweiten Stift (122) zu verändern.

2. Doppelstift-Prüfspitze nach Anspruch 1, die des Weiteren umfasst:
ein Schwenk-Betätigungselement (140), das mit dem Schwenkarm (130) über einen Drehzapfen (132) verbunden ist, um den Schwenkarm (130) zu drehen.

3. Doppelstift-Prüfspitze nach Anspruch 1, wobei der Schwenkarm (130) so ausgeführt ist, dass er sich in einer Ebene dreht, die im Wesentlichen parallel zum vorderen Ende des Prüfspitzenkopfes (102) ist.

4. Doppelstift-Prüfspitze nach Anspruch 1, wobei der zweite Stift (122) einziehbar an dem Schwenkarm (130) angebracht ist.

5. Doppelstift-Prüfspitze nach Anspruch 1, die des Weiteren umfasst:
eine Test-Prüfspitze (116), die mit dem Prüfspitzenkopf (102) verbunden ist, wobei eine erste Zuleitung der Test-Prüfspitze (116) mit dem ersten Stift (120) verbunden ist und eine zweite Zuleitung an der Test-Prüfspitze (116) mit dem zweiten Stift (122) verbunden ist.

6. Doppelstift-Prüfspitze nach Anspruch 5, wobei der Prüfspitzenkopf (120) enthält:
eine Kontaktröhre (110), die so ausgeführt ist, dass sie die Test-Prüfspitze aufnimmt.

7. Doppelstift-Prüfspitze nach Anspruch 1, wobei der erste Stift (120) einziehbar an dem Prüfspitzenkopf (102) angebracht ist.

8. Doppelstift-Prüfspitze nach Anspruch 1, wobei der erste Stift (120) im Wesentlichen parallel zu dem zweiten Stift (122) ist.

9. Automatisiertes Verfahren zum Prüfen einer Leiterplatte, das die folgenden Schritte umfasst:
Identifizieren eines ersten und eines zweiten Prüfknotens auf der Leiterplatte;
Bestimmen einer Ausrichtung des ersten und des zweiten Prüfknotens sowie eines linearen Abstandes dazwischen;
Verändem eines Abstandes zwischen einem ersten Stift (120) und einem zweiten Stift (122) eines Prüfspitzenkopfes (102);
Positionierens des Prüfspitzenkopfes so, dass der erste Stift an den ersten Prüfknoten angrenzt und der zweite Stift an den zweiten Prüfknoten angrenzt;
Herstellen von Kontakt des ersten Stiftes mit dem ersten Knoten; und
Herstellen von Kontakt des zweiten Stiftes mit dem zweiten Knoten;
wobei das Verfahren des Weiteren **dadurch gekennzeichnet ist, dass** der Schritt des Verändems ausgeführt wird, indem ein Schwenkarm (130), an dem der zweite Stift fest angebracht ist, gedreht wird, um Übereinstimmung mit dem linearen Abstand herzustellen.

10. Verfahren nach Anspruch 9, das des Weiteren den folgenden Schritt umfasst:
Verbinden einer ersten Zuleitung einer Prüfspitze (116) mit dem ersten Stift und einer zweiten Zuleitung der Prüfspitze mit dem zweiten Stift.

## Revendications

1. Sonde (100) à deux broches ayant une configuration destinée à une manipulation par un robot afin que des tests d'une carte de circuit soient faciles, comprenant :
un corps (104) de sonde ayant une configuration pouvant être raccordée au robot,
une tête (102) de sonde couplée au corps (104) de sonde, une extrémité externe de la tête (102) de sonde ayant une configuration permettant un positionnement près de la carte de circuit,
une première broche (120) qui s'étend depuis l'extrémité externe de la tête (102) de sonde et qui occupe une position fixe par rapport à la tête (102) de sonde, la sonde (100) à deux broches étant en outre **caractérisée par** :
une seconde broche (122) raccordée à une extrémité d'un bras de pivot (130) ayant un emplacement fixe et s'étendant depuis l'extrémité externe de la tête (102) de sonde, le bras de pivot (130) pouvant tourner afin qu'il fasse varier la distance comprise entre la première broche (120) et la seconde broche (122).

2. Sonde à deux broches selon la revendication 1, comprenant en outre :
un organe (140) de manoeuvre de pivot couplé au bras de pivot (130) par un pivot (132) et destiné à faire tourner le bras de pivot (130).

3. Sonde à deux broches selon la revendication 1, dans laquelle le bras de pivot (130) a une configuration permettant sa rotation dans un plan pratiquement parallèle à l'extrémité externe de la tête (102) de sonde.

4. Sonde à deux broches selon la revendication 1, dans laquelle la seconde broche (122) est montée de façon rétractable sur le bras de pivot (130).

5. Sonde à deux broches selon la revendication 1, comprenant en outre :
une sonde (116) de test couplée à la tête (102) de sonde, un premier fil de la sonde (116) de test étant connecté à la première broche (120) et un second fil de la sonde (116) de test étant connecté à la seconde broche (122).

6. Sonde à deux broches selon la revendication 5, dans laquelle la tête (102) de sonde comprend :
un tube de contact (110) ayant une configuration permettant le logement de la sonde de test.

7. Sonde à deux broches selon la revendication 1, dans laquelle la première broche (120) est montée de façon rétractable sur la tête (102) de sonde.

8. Sonde à deux broches selon la revendication 1, dans laquelle la première broche (120) est pratiquement parallèle à la seconde broche (122).

9. Procédé de test automatique d'une carte de circuit, comprenant les étapes suivantes :
l'identification d'un premier et d'un second noeud de test sur la carte de circuit,
la détermination d'une distance linéaire entre le premier et le second noeud de test et de l'orientation de ces noeuds,
la variation de la distance comprise entre une première broche (120) et une seconde broche (122) d'une tête (102) de sonde,
le positionnement de la tête de sonde afin que la première broche soit adjacente au premier noeud de test et que la seconde broche soit adjacente au second noeud de test,
la mise de la première broche au contact du premier noeud, et
la mise de la seconde broche au contact du second noeud,
dans lequel le procédé est en outre **caractérisé en ce que** l'étape de variation est exécutée par rotation d'un bras de pivot (130) sur lequel la seconde broche est montée de manière fixe afin qu'elle corresponde à la distance linéaire.

10. Procédé selon la revendication 9, comprenant en outre l'étape suivante :
la connexion d'un premier fil d'une sonde de test (116) à la première broche et d'un second fil de la sonde de test à la seconde broche.
